Europäisches Patentamt

European Patent Office

Office européen des brevets

(11) Veröffentlichungsnummer: **0 200 891**
**B1**

(19)

(12) # EUROPÄISCHE PATENTSCHRIFT

(45) Veröffentlichungstag der Patentschrift:
06.12.89

(51) Int. Cl.⁴: **G01N 24/06**, G05F 7/00

(21) Anmeldenummer: 86103530.1

(22) Anmeldetag: 15.03.86

(54) Verfahren und Vorrichtung zum Homogenisieren des Feldes einer Magnetspule.

(30) Priorität: 28.03.85 DE 3511303

(43) Veröffentlichungstag der Anmeldung:
17.12.86 Patentblatt 86/46

(45) Bekanntmachung des Hinweises auf die Patenterteilung:
06.12.89 Patentblatt 89/49

(84) Benannte Vertragsstaaten:
CH DE FR GB LI

(56) Entgegenhaltungen:
EP-A- 0 033 703
GB-A- 2 070 254

REVIEW OF SCIENTIFIC INSTRUMENTS, Band 52, Nr. 10, Oktober 1981, Seiten 1501-1508, American Institute of Physics, New York, US; H. SAINT-JAIMES et al.: "Optimization of homogeneous electromagnetic coil systems: Application to whole-body NMR imaging magnets"
dichloro[hydrotris(1-pyrazolyl)borato]oxotechneti-um(V)" 000
MAGNETIC RESONANCE IN MEDICINE, Band 1, Nr. 1, März 1984, Seiten 44-65, Academic Press Inc., New York US; F. ROMEO et al.: "Magnet field profiling: Analysis and correcting coil design"

(73) Patentinhaber: Spectrospin AG, Industriestrasse 26, CH-8117 Zürich-Fällanden(CH)

(72) Erfinder: Tschopp, Werner, Dr., Eggenbergstrasse 11, CH-8127 Forch(CH)

(74) Vertreter: Patentanwälte Kohler - Schwindling - Späth, Hohentwielstrasse 41, D-7000 Stuttgart 1(DE)

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch - einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zum Homogenisieren des Feldes einer aus einer Haupt-Stromquelle und supraleitend betreibbaren und mit Supraleitungs-Schaltern kurzschließbaren Magnet-Hauptspule und mindestens zwei von der Hauptspule getrennten Zusatzspulen mit nicht verschwindendem Feldgradienten mindestens erster bis p-ter Ordnung in der Spulenachse bestehenden Spulenanordnung.

An die Homogenität der Magnetfelder, die von Spulenanordnungen erzeugt werden, werden häufig außerordentliche Anforderungen gestellt, die nicht durch das Einhalten vorgegebener Konstruktionsdaten erfüllt werden können. Daher ist es notwendig, das Magnetfeld der Spulenanordnung zu messen und durch die Anwendung von Zusatzspulen so lange zu korrigieren, bis die gewünschte Homogenität erreicht ist. Solche Verfahren werden beispielsweise verwendet, um das Feld von supraleitenden Spulenanordnungen zu homogenisieren, die für Kernresonanz-Messungen, insbesondere für die Kernspintomographie, verwendet werden.

Wegen der Bedeutung, die Spulenanordnungen zur Erzeugung von Magnetfeldern hoher Homogenität gewonnen haben, sind einschlägige Verfahren zum Homogenisieren des Feldes solcher Spulenanordnungen in zahlreichen Veröffentlichungen behandelt. So ist beispielsweise aus EP-A 0 033 703 eine Spulenanordnung bekannt, die außer einer aus zwei Spulenpaaren bestehenden Hauptspule noch zwei Zusatzspulen aufweist, die konzentrisch zu der Achse der Hauptspule angeordnet sind. Die Anordnung, die Größe und die Stärke des die drei Spulenpaare durchfließenden Stromes erlaubt es, eine große Homogenität des Magnetfeldes zu erreichen. Es handelt sich hierbei jedoch um resistive Spulen, bei denen eine Variation der Anordnung der Spulen sowie der Stärke des die Spulen durchfließenden Stromes ohne weiteres möglich ist.

Eine andere Methode zur Erzeugung eines homogenen Magnetfeldes ist aus der GB-A 2 070 254 bekannt. Hier werden bewußt durch unterschiedliche Spulenanordnungen zwei inhomogene Felder erzeugt und einander in der Weise überlagert, daß sich in einem gewünschten Bereich ein homogenes Magnetfeld ergibt. Die bekannte Spulenanordnung setzt sich aus einer Vielzahl von Teilspulen zusammen, und es werden in der genannten Druckschrift die Regeln behandelt, nach denen die Teilspulen zu bemessen sind, um zu der gewünschten Homogenität des Magnetfeldes zu kommen. Auch hierbei handelt es sich jedoch nicht um eine supraleitende Spulenanordnung, so daß es einfach ist, die Konfiguration der Spule und den die einzelnen Spulenteile durchfließenden Strom so lange zu ändern, bis die gewünschte Homogenität erreicht ist. Ähnlich liefern auch die Aufsätze in Review of Scientific Instruments, Band 52, Nr. 10, Oktober 1981, Seiten 1501 bis 1508 sowie in Magnetic Resonance in Medicine, Band 1, Nr. 1, März 1984, Seiten 44 bis 65, nur theoretische Grundlagen für die Berechnung von Spulenanordnungen, ohne aber die praktischen Probleme zu lösen, die sich beim Bau von supraleitenden Spulenanordnungen ergeben.

Da, wie bereits erwähnt, die geforderte Homogenität des Magnetfeldes nicht durch genaues Einhalten der Konstruktions-Größen erzielen lassen, sondern nach Fertigstellung der Spulenanordnung Korrekturmaßnahmen erforderlich sind, ging man bei der Herstellung von supraleitenden Spulenanordnungen bisher so vor, daß die fertig gewickelte Hauptspule im flüssigen Helium auf eine Supraleitungs-Temperatur abgekühlt und alsdann mit Nennstrom beaufschlagt wurde. Man hat dann ein oder mehrere Feldprofile gemessen, worunter im folgenden der Verlauf des magnetischen Feldes entlang einer oder mehreren Spulenachsen verstanden wird. Aus den Meßdaten des oder der Feldprofile hat man dann unterschiedliche Korrekturspulen in Gestalt von Zusatzwindungen berechnet, die dann später der Hauptspule hinzugefügt und mit dieser in Reihe geschaltet wurden. Da Anzahl und Lage der Korrekturwindungen vom Meßergebnis abhing, mußte man zunächst die Hauptspule wieder auf Raumtemperatur bringen und dann aus dem Cryostaten ausbauen, um die berechneten Zusatzwindungen am Spulenkörper anbringen zu können.

Die Hauptspule mit den eigens für das jeweilige Exemplar der Hauptspule berechneten und angebrachten Zusatzwindungen wurde dann wieder in flüssiges Helium gebracht und auf Supraleitungstemperatur abgekühlt. Danach wurden das oder die Feldprofile erneut ausgemessen. Zeigte sich dabei, daß die erhaltenen Feldprofile immer noch nicht die geforderte Homogenität aufwiesen, mußte der gesamte, vorstehend beschriebene Vorgang der Berechnung von Zusatzwindungen, des Erwärmens, des Anbringens der Zusatzwindungen, des Wieder-Abkühlens und Messens wiederholt werden.

In der Regel waren hierfür zwei bis drei, gelegentlich sogar noch mehr Versuchszyklen erforderlich, bis ein zufriedenstellendes Ergebnis, d.h. eine ausreichend hohe Homogenität des gesamten Spulensystems erreicht war.

Das vorstehend beschriebene bekannte Verfahren war aber nicht nur mühsam und zeitaufwendig, sondern erforderte auch bei der Durchführung der geschilderten Versuchszyklen erhebliche Mengen an flüssigem Helium zum Abkühlen des Spulensystems, insbesondere wenn es sich um großvolumige Spulen handelte, wie sie in der Kernspintomographie verwendet werden. Die Hersteller bzw. Betreiber derartiger Spulensysteme waren daher gezwungen, entweder beträchtliche Abdampfverluste von Helium hinzunehmen oder komplizierte Helium-Rückgewinnungsanlagen zu installieren, da die Kosten für flüssiges Helium beträchtlich sind.

Der Erfindung liegt daher die Aufgabe zugrunde, ein Verfahren der eingangs genannten Art dahingehend weiterzubilden, daß die Homogenisierung einer supraleitenden Spulenanordnung mit geringem Zeitaufwand und insbesondere ohne die Notwendigkeit des mehrfachen Abkühlens und Aufwärmens des Spulensystems gelingt.

Diese Aufgabe wird erfindungsgemäß durch ein Verfahren gelöst, das die folgenden Schritte umfaßt:

a) Anschließen der Zusatzspulen an jeweils eine gesonderte Stromquelle und einen des Kurzschließen der jeweiligen Zusatzspule gestattenden Supraleitungs-Schalter;

b) Kühlen der Hauptspule und der Zusatzspulen auf eine die Supraleitung ermöglichende Temperatur;

c) Speisen der Hauptspule (25) mit Nennstrom ($i_m$);

d) Messen des Profils der Hauptspule (25);

e) Ermitteln der Gradienten ($G_1$ ..., $G_p$) der Hauptspule (25) aus dem gemessenen Profil;

f) Ermitteln der Gradienten ($g_{11}$ ..., $g_{pp}$) der Zusatzspulen (10 bis 13)

g) Ermitteln von Korrekturströmen ($i_1$ ..., $i_p$) für die Zusatzspulen (10 bis 13) aus dem Gleichungssystem:

$$\sum_{n=1}^{p} g_{n1} i_1 = -G_1 i_m$$

$$\sum_{n=1}^{p} g_{n2} i_2 = -G_2 i_m$$

$$\vdots$$

$$\sum_{n=1}^{p} g_{np} i_p = -G_p i_m;$$

h) Einspeisen der ermittelten Korrekturströme ($i_1$ ..., $i_p$) in die Zusatzspulen (10 bis 13);

i) Schließen der Supraleitungs-Schalter (14 bis 17) der Zusatzspulen (10 bis 13).

Die Erfindung löst damit die zugrundeliegende Aufgabe vollkommen, weil die Zusatzspulen von Anfang an zusammen mit der Hauptspule montiert und mit dieser auf Supraleitungs-Temperatur abgekühlt werden. Durch Ermitteln der erforderlichen Korrekturströme für jede einzelne Zusatzspule und das Einspeisen dieser Korrekturströme in die Zusatzspulen wird erreicht, daß ohne die Notwendigkeit eines erneuten Erwärmens des Spulensystems im Heliumbad die Homogenisierung mit rein elektrischen Mitteln vorgenommen wird, ohne das Spulensystem zunächst aufwärmen und mechanisch modifizieren zu müssen.

Da die erforderlichen Messungen und Ermittlungen relativ schnell ausführbar sind, jedenfalls wesentlich schneller als mechanische Umrüstarbeiten mit Aufwärmen und Abkühlen des Spulensystems, kann das Feld der Hauptspule mittels der Korrekturspulen nicht nur sehr schnell homogenisiert werden, es entfallen darüber hinaus auch die erheblichen Heliumverluste, wie sie aus den eingangs genannten Gründen bei den bekannten Verfahren und Vorrichtungen unvermeidbar sind.

Gemäß einer ersten Variante des erfindungsgemäßen Verfahrens werden die Gradienten der Zusatzspulen aus deren Geometrie bestimmt.

Diese Maßnahme hat den Vorteil, daß bei vorgegebener Geometrie, d.h. Abmessungen und Lage der Zusatzspulen, deren Gradienten mit im vorliegenden Fall hinreichender Genauigkeit errechnet werden können, wie dies an sich bekannt ist. Zwar weisen auch die Zusatzspulen, nachdem sie eingebaut und erregt sind, einen konstruktiven Fehler auf, der dem Fehler der Hauptspule in der Größenordnung entspricht, dies wirkt sich jedoch in vielen Fällen deswegen nicht störend aus, weil das Feld der Zusatzspulen um einige Größenordnungen kleiner ist als das Feld der Hauptspule und daher auch Fehler der Zusatzspulen nur um den entsprechenden Faktor (beispielsweise $10^{-4}$) vermindert in das Hauptfeld eingehen.

Bei einer anderen Variante der Erfindung werden jedoch die Gradienten der Zusatzspulen dadurch bestimmt, daß die Zusatzspulen mit einem Referenzstrom gespeist, ihre Profile gemessen und die Gradienten aus den Profilen bestimmt werden.

Diese Maßnahme hat den Vorteil, daß im Falle höchster Anforderungen auch konstruktive, geometrische Fehler der Zusatzspulen sich nicht auswirken, weil von den tatsächlich vorhandenen und in Betrieb befindlichen Zusatzspulen ausgegangen wird.

Bei einem Ausführungsbeispiel der Erfindung werden die Supraleitungs-Schalter der Hauptspule nach dem Einspeisen der Korrekturströme geschlossen.

Diese Maßnahme hat den Vorteil, daß die zugeschalteten Zusatzspulen keine induzierten Beiträge in die Hauptspule leisten, weil deren Strom bis zum letzten Verfahrensschritt durch das angeschlossene Netzgerät bestimmt wird. Erst wenn alle Spulen mit ihrem endgültigen Strom beaufschlagt sind, werden demzufolge sämtliche Supraleitungs-Schalter geschlossen, so daß nach dem Schließen der Supraleitungs-Schalter keine Veränderungen durch induzierte Ströme mehr eintreten können.

Bei einer anderen Variante des erfindungsgemäßen Verfahrens wird der Supraleitungs-Schalter der Hauptspule hingegen schon nach dem Speisen mit Nennstrom geschlossen, nach dem Einspeisen der Korrekturströme das Feld der Hauptspule gemessen und bei Überschreiten einer vorgegebenen Abweichung von einem nennstromabhängigen Wert die Schritte c) bis i) mit einem korrigierten Nennstrom wiederholt.

Bei dieser Variante des Verfahrens wird also im Gegensatz zur vorher beschriebenen Variante in Kauf genommen, daß in die supraleitende und "persistent" geschaltete Hauptspule noch Strombeiträge infolge des späteren Einspeisens der Korrekturströme in die Zusatzspulen induziert werden. Die sich einstellenden geringfügigen Fehler werden durch einen zyklischen Korrekturprozeß wieder eliminiert, indem beispielsweise bei einer Schwächung des Hauptfeldes durch die später in die Zusatzspulen eingespeisten Korrekturströme im nächsten Zyklus ein etwas angehobener Nennstrom in die Hauptspule eingespeist wird. Diese Variante des erfindungsgemäßen Verfahrens hat jedoch den Vorteil, daß das Feld der Hauptspule länger stabil ist, weil nach dem "persistent"-Schalten der Hauptspule keine Fluktuationen durch eine endliche Stabilität des Netzgerätes auftreten können.

Gemäß einer Weiterbildung der Erfindung können die Schritte der Ermittlung der Feldprofile, der Berechnung der Korrekturströme und der Einspeisung der Korrekturströme auch zyklisch wiederholt ablaufen, umd die Homogenisierung schrittweise immer mehr zu verbessern, bis eine vorgegebene Homogenität erreicht ist.

Zwar ist es aus der Technik der Kernresonanzexperimente bekannt, zum Homogenisieren von nicht ausreichend homogenen Magnetfeldern sogenannte Shimspulen zu verwenden, diese Shimspulen beruhen jedoch auf anderen Prinzipien als die Zusatzspulen der vorliegenden Erfindung.

Zunächst werden mit den Shimspulen bekannter Art üblicherweise nur sehr kleine Probenräume homogenisiert, wie sie für Probendimensionen erforderlich sind, die etwa den Abmessungen eines Probenröhrchens entsprechen.

Weiterhin sind die bekannten Shimspulen so ausgelegt, daß jeweils ein Spulensystem für einen Gradienten einer bestimmten Ordnung und nur für diesen Gradienten vorgesehen ist, weil dieses Shimspulen-System nur einen Gradienten dieser einen Ordnung, nicht jedoch Gradienten anderer Ordnung erzeugt.

Solche, in der Fachsprache als "orthogonale" Shimspulen bezeichnete Systeme bestehen beispielsweise bei einem Shimspulen-System für einen Gradienten dritter Ordnung ($Z^3$) aus symmetrischen Spulenpaaren, so daß die Gradienten gerader Ordnung ($Z^2$, $Z^4$, ...) aus Symmetriegründen verschwinden. Man kann in diesem Beispielsfall die Positionierung der Spulenpaare für den Gradienten dritter Ordnung ($Z^3$) so wählen, daß auch die Gradienten erster und fünfter Ordnung ($Z$, $Z^5$) verschwinden. Auf diese Weise erzeugt das als Beispiel genannte Spulenpaar für den Gradienten dritter Ordnung ($Z^3$) nur einen reinen Feldgradienten dritter Ordnung, ohne daß optimale Einstellungen der Shimspulen-Systeme für Gradienten anderer Ordnung beeinflußt werden.

Bei herkömmlichen Kernresonanzexperimenten können so die einzelnen Gradienten nacheinander optimiert werden.

Wie bereits erwähnt, ist aufgrund der geforderten Orthogonalitäts-Bedingung für jeden einzelnen Feldgradienten ein System von Shimspulen erforderlich, beispielsweise benötigt man zum Nachstellen von vier gewünschten Feldgradienten 16 Spulen.

Für die vorliegend im Vordergrund stehende Anwendung der Erfindung bei Spulen für Kernspintomographie-Messungen sind derartige hochkomplexe Spulensysteme jedoch deswegen unbrauchbar, weil aufgrund des großen Probenvolumens, das für die Ganzkörpertomographie den Abmessungen eines menschlichen Körpers entspricht, dicke Spulenpakete erforderlich wären.

Zwar verwendet man auch bei diesen Anwendungen Shimspulen, jedoch sind diese aus Kostengründen wesentlich flacher ausgebildet, als dies eigentlich erforderlich wäre. Der Korrekturbereich derartiger "Shimspulen" ist daher sehr begrenzt. In der Praxis müßte man z.B. bei einer 3 cm dicken Solenoidspule von 50 cm Durchmesser ein Spulenpaket von 1 cm Dicke als "echte" Shims vorsehen, was zu einer enormen Kostenerhöhung angesichts des sehr teuren supraleitenden Drahtes führt. Man verwendet daher nur sehr dünne Zusatzspulen mit entsprechend vermindertem Korrekturbereich.

Die vorliegende Erfindung löst sich demgegenüber von den bekannten Anordnungen mit Shimspulen-Systemen, indem bewußt auf die Orthogonalitäts-Bedingung verzichtet und zugelassen wird, daß jede Zusatzspule alle Feldgradienten erzeugt, die letztendlich nachgestellt werden sollen, beispielsweise alle Feldgradienten von der ersten bis zur vierten Ordnung ($Z$ bis $Z^4$).

Durch die unterschiedliche Positionierung jeder Zusatzspule ist jedoch die Verteilung der Stärken dieser Gradienten von Zusatzspule zu Zusatzspule verschieden.

Durch das Ausmessen des Feldprofils, das Bestimmen der erforderlichen Korrekturströme und das Einspeisen der Korrekturströme werden "mit einem Schlag" alle gewünschten Gradienten kompensiert, und es kann – je nach Komplexität des verwendeten Verfahrens – eine Homogenisierung bis hin zu Feldgradienten hoher Ordnung vorgenommen werden.

Gegenstand der Erfindung ist auch eine Vorrichtung zum Homogenisieren des Feldes einer aus einer Haupt-Stromquelle und supraleitend betreibbaren und mit Supraleitungs-Schaltern kurzschließbaren Magnet-Hauptspule und mindestens zwei von der Hauptspule getrennten Zusatzspulen mit nicht verschwindendem Feldgradienten mindestens erster bis p-ter Ordnung in der Spulenachse bestehenden Spulenanordnung. Diese Vorrichtung ist nach der Erfindung in der Weise ausgebildet, daß die Zusatzspulen als supraleitende Spulen mit parallel geschalteten Supraleitungs-Schaltern ausgebildet sind, daß die Zusatzspulen mit je einer Stromquelle verbunden sind, daß ein Ausgang des Magnetfeld-Meßgerätes mit einem Feldprofil-Speicher verbunden ist und daß der Feldprofil-Speicher und ein Steuergerät an ein Rechenwerk angeschlossen sind, dessen Ausgänge mit einem Gradientenspeicher sowie der Haupt-Stromquelle und den Stromquellen für die Zusatzspulen verbunden sind. Diese Vorrichtung gestattet es, Spulenanordnungen nach dem erfindungsgemäßen Verfahren mit sehr hoher Genauigkeit so einzustellen, daß die nach der Konstruktion vorgesehene Homogenität des Magnetfeldes auch erreicht wird.

Weitere Vorteile der Erfindung ergeben sich aus der Beschreibung und der beigefügten Zeichnung.

Ausführungsbeispiele der Erfindung sind in der Zeichnung dargestellt und werden in der nachfolgenden Beschreibung näher erläutert. Es zeigen:

Fig. ein Blockschaltbild einer erfindungsgemäßen Vorrichtung, wie sie zur Durchführung des erfindungsgemäßen Verfahrens verwendet werden kann;

Fig. 2 ein Dimensionierungsbeispiel für ein System von Zusatzspulen nach der vorliegenden Erfindung;

Fig. 3 den axialen Verlauf eines Magnetfeldes einmal ohne und einmal mit erfindungsgemäßer Homogenisierung.

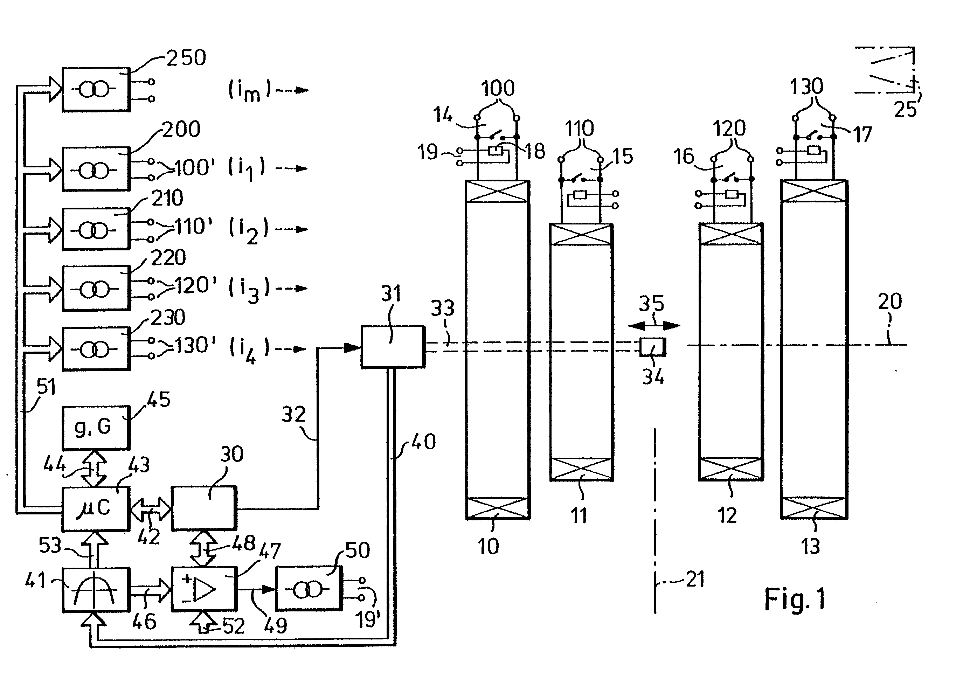

In Fig. 1 bezeichnen 10, 11, 12 und 13 vier Zusatzspulen, wobei die Zusatzspulen 10 und 13 sowie 11 und 12 paarweise angeordnet sind, was jedoch nicht erforderlich ist.

Obwohl man im Rahmen der vorliegenden Erfindung grundsätzlich in der Geometrie, d.h. Lage und Abmessungen der Zusatzspulen frei ist, sofern nur deren Feldgradienten bis zu der höchsten noch zu korrigierenden Ordnung der Hauptfeld-Gradienten nicht verschwinden, wird man die Zusatzspulen in der Praxis doch so anordnen, daß deren Gradient der ersten geraden, nicht mehr zu korrigierenden Ordnung verschwindet. Will man also z.B. die Gradienten erster bis vierter Ordnung kompensieren, wird man durch die Geometrie der Zusatzspulen deren Gradienten sechster Ordnung zum Verschwinden bringen.

Die Zusatzspulen 10, 11, 12, 13 sind mit Anschlüssen 100, 110, 120, 130 versehen, die mittels Supraleitungs-Schaltern 14, 15, 16, 17 kurzschließbar sind. Hierzu sind Heizwiderstände vorgesehen, von denen einer mit 18 und dessen Anschlüsse mit 19 bezeichnet sind. Wie bekannt ist, erwärmt der Heizwiderstand 18 im Betrieb das räumliche Gebiet des Supraleitungs-Schalters 14, so daß dieses Gebiet sich im Zustande der Normalleitung befindet. Die Zusatzspule 10 kann in diesem Falle über die Klemmen 100 von außen mit Strom versorgt werden. Wird nun jedoch die Ansteuerung des Heizwiderstandes 18 beendet, gelangt der sich in flüssigem Helium befindliche Supraleitungs-Schalter 14 auf Supraleitungs-Temperatur und schließt die Zusatzspule 10 kurz, die dann im "persistent mode" läuft.

Die Längsachse (z) des Spulensystems ist mit 20 und eine Hochachse (x, y) ist mit 21 bezeichnet. Die Magnetfeld-Hauptspule, die innerhalb oder außerhalb der Zusatzspulen 10 bis 13 angeordnet sein kann, ist in Fig. 1 mit 25 angedeutet.

Zur Homogenisierung des Feldes der Hauptspule 25 dient eine Schaltungsanordnung, die in der linken Hälfte von Fig. 1 schematisch dargestellt ist.

Ein Steuergerät 30 steuert ein Magnetfeld-Meßgerät 31 über eine Steuerleitung 32. Das Magnetfeld-Meßgerät 31 weist eine verfahrbare Stange 33 auf, an deren Ende sich ein magnetfeldempfindlicher Sensor 34 befindet, der mittels eines in Fig. 1 nicht dargestellten Antriebes in Richtung des Doppelpfeiles 35, d.h. in Richtung der Längsachse 20, verfahrbar ist.

Die in dieser Weise entlang der Längsachse 20 aufgenommenen Meßwerte, d.h. das Feldprofil in z-Richtung, werden über eine Datenleitung 40 in einen Feldprofil-Speicher 41 eingeschrieben. Über eine weitere Datenleitung 42 ist das Steuergerät 30 mit einem Rechenwerk 43 verbunden, das seinerseits über eine weitere Datenleitung 44 an einen Gradientenspeicher 45 angeschlossen ist. Über eine Datenleitung 46 steht der Feldprofil-Speicher 41 mit einem Komparator 47 in Verbindung, der einerseits über eine Datenleitung 48 mit dem Steuergerät 30 in Wechselwirkung steht, weiterhin mit einer Steuerleitung 49 an eine Stromquelle 50 angeschlossen ist und dem schließlich über einen Dateneingang 52 ein Soll-Wert zuführbar ist. Der Feldprofil-Speicher ist über eine Datenleitung 53 ebenfalls an das Rechenwerk 43 angeschlossen, dessen Ausgang über eine Datenleitung 51 mit einer Haupt-Stromquelle 250 sowie vier Stromquellen 200, 210, 220, 230 verbunden ist.

Am Ausgang der Haupt-Stromquelle 250 ist ein Strom $i_m$ für die Hauptspule 25 abnehmbar, und Ausgänge 100', 110', 120', 130' der Stromquellen 200, 210, 220, 230 sind mit den Anschlüssen 100, 110, 120, 130 der Zusatzspulen 10, 11, 12, 13 verbunden, so daß in diese Korrekturströme $i_1$, $i_2$, $i_3$, $i_4$ einspeisbar sind.

Es versteht sich, daß das in Fig. 1 dargestellte Ausführungsbeispiel mit vier Zusatzspulen 10 bis 13 nur beispielhaft zu verstehen ist, selbstverständlich sind auch Anordnungen mit einer geringeren oder höheren Anzahl von Zusatzspulen und dann entsprechend auch Stromquellen im Rahmen der vorliegenden Erfindung verwendbar.

Die Wirkungsweise der in Fig. 1 dargestellten Anordnung bzw. des damit durchgeführten Verfahrens ist wie folgt:

Das gesamte Spulensystem mit Hauptspule 25 und Zusatzspulen 10, 11, 12, 13 wird, komplett montiert, in einen Cryostaten eingebracht und durch Abkühlen auf die Temperatur des flüssigen Heliums in einen Zustand gebracht, bei dem in der Hauptspule 25 und den Zusatzspulen 10, 11, 12, 13 Supraleitung möglich ist.

Durch Betätigen der Supraleitungs-Schalter 18 sind sämtliche Spulen in diesem Zustand noch an die Stromquellen 250, 200, 210, 220, 230 angeschlossen und der sie durchsetzende Strom demzufolge von den Stromquellen bestimmt.

Das Steuergerät 30 stellt nun über das Rechenwerk 43 und die Datenleitung 51 die Stromquellen so ein, daß die Hauptspule 25 mit Nennstrom $i_m$ betrieben wird und die Zusatzspulen 10 bis 13 stromlos sind.

Über die Steuerleitung 32 wird nun das Magnetfeld-Meßgerät 31 in Betrieb gesetzt, und der Sensor 34 durchfährt das Spulensystem entlang der Längsachse 20. Über die Datenleitung 40 werden die entsprechenden Meßwerte in den Feldprofil-Speicher 41 eingegeben, bis das Feldprofil vollständig aufgenommen ist.

Über die Datenleitung 42 wird nun im Steuergerät 43 ein Verfahren gestartet, das in an sich bekannter Weise aus dem gemessenen Feldprofil die Gradienten $G_0$, $G_1$, $G_2$, $G_3$, $G_4$ ... bestimmt. Diese gemessenen Feldgradienten des Feldes der Hauptspule werden alsdann im Gradientenspeicher 45 abgelegt.

Das Steuergerät 30 schaltet nun den Nennstrom $i_m$ in der Hauptspule 25 ab und beaufschlagt eine der Zusatzspulen, beispielsweise die Zusatzspule 10 über die Stromquelle 200 mit einem Referenzstrom. Es wird nun in der vorstehend beschriebenen Weise das Feldprofil für diese eine Zusatzspule aufgenommen, und es werden die Feldgradienten $g_{10}$, $g_{11}$, $g_{12}$, $g_{13}$, $g_{14}$ ... bestimmt und im Gradientenspeicher 45 abgelegt.

In entsprechender Weise werden die Feldprofile und Feldgradienten sämtlicher Zusatzspulen 10 bis 13 nacheinander ermittelt.

Es muß jedoch betont werden, daß diese Vorgehensweise nur beispielhaft zu verstehen ist und eine besonders leichte Ermittlung der jeweiligen Feldgradienten G, g ermöglicht, es sind selbstverständlich auch andere Vorgehensweisen denkbar, bei denen mehrere Spulen gleichzeitig eingeschaltet sind und die Feldgradienten G, g mit entsprechend aufwendigeren Verfahren ermittelt werden. Man kann erfindungsgemäß auch die Gradienten $g_{11}$ ..., $g_{pp}$ der Zusatzspulen 10 bis 13 aus der Geometrie der Zusatzspulen 10 bis 13 errechnen.

Der nun folgende Verfahrensschritt macht sich die nachstehende Überlegung zunutze:

Bezeichnet man die von den Zusatzspulen 10, 11, 12, 13 erzeugten magnetischen Felder mit $H_1$, $H_2$, $H_3$, und $H_4$, läßt sich das im Schnittpunkt der Achsen 20, 21 erzeugte magnetische Feld durch eine Reihenentwicklung darstellen:

$$H_1 = (g_{10}+g_{11}z+g_{12}z^2+g_{13}z^3+g_{14}z^4+ ...) i_1$$
$$H_2 = (g_{20}+g_{21}z+g_{22}z^2+g_{23}z^3+g_{24}z^4+ ...) i_2$$
$$H_3 = (g_{30}+g_{31}z+g_{32}z^2+g_{33}z^3+g_{34}z^4+ ...) i_3$$
$$H_4 = (g_{40}+g_{41}z+g_{42}z^2+g_{43}z^3+g_{44}z^4+ ...) i_4$$

In entsprechender Weise gilt für die Entwicklung des Feldes der Hauptspule 25 im Schnittpunkt der Achsen 20, 21:

$$H_m = (G_0+G_1z+G_2z^2+G_3z^3+G_4z^4+...) i_m$$

Will man nun bei dem vorstehend als Beispiel genannten System vierter Ordnung oder, allgemein gesagt, bei einem System p'ter Ordnung die Gradienten $G_1$... $G_p$ der Hauptspule 25 durch die Gradienten $g_{11}$ bis $g_{pp}$ der Korrekturspulen 10 bis 13 kompensieren, muß gelten:

$$g_{11}i_1+g_{21}i_2+g_{31}i_3+g_{41}i_4 = -G_1i_m$$
$$g_{12}i_1+g_{22}i_2+g_{32}i_3+g_{42}i_4 = -G_2i_m$$
$$g_{13}i_1+g_{23}i_2+g_{33}i_3+g_{43}i_4 = -G_3i_m$$
$$g_{14}i_1+g_{24}i_2+g_{34}i_3+g_{44}i_4 = -G_4i_m$$

Man erkennt, daß zum Ermitteln der erforderlichen Korrekturströme $i_1$, $i_2$, $i_3$, $i_4$ nur ein System von p, z.B. vier Gleichungen mit p, z.B. vier Unbekannten, zu lösen ist, was ohne größere Schwierigkeiten möglich ist.

Das Rechenwerk 43 kann nun aufgrund der Befehle des Steuergerätes 30 mit den im Gradientenspeicher 45 abgespeicherten Daten in der vorstehend beschriebenen Weise die Korrekturströme $i_1$, $i_2$, $i_3$ und $i_4$ berechnen und über die Datenleitung 51 die Stromquellen 200, 210, 220, 230 in entsprechender Weise einstellen, so daß die Zusatzspulen 10, 11, 12, 13 mit den jeweils zugehörigen Korrekturströmen $i_1$, $i_2$, $i_3$, und $i_4$ durchsetzt werden.

In einem weiteren Schritt veranlaßt nun das Steuergerät 30, daß das Magnetfeld-Meßgerät 31 mit dem Sensor 34 das axiale Feldprofil nochmals aufnimmt und im Feldprofil-Speicher 41 ablegt. Über die Datenleitung 46 wird das Profil des korrigierten Feldes jetzt dem Komparator 47 zugeführt, an dessen Dateneingang 42 ein Bezugswert anliegt. Das Steuergerät 30 fragt nun im Komparator 47 ab, ob der vorgegebene Soll-Wert bereits erreicht wurde und veranlaßt, daß falls dies nicht der Fall ist, das Verfahren nochmals wiederholt wird, um den Korrekturströmen $i_1$, $i_2$, $i_3$, $i_4$ in einem zweiten Schritt einer Feinkorrektur nochmals geringfügige Korrekturströme zu überlagern.

Diese Prozedur kann, falls erforderlich, mehrfach wiederholt werden, bis der Komparator 47 meldet, daß der am Dateneingang 52 vorgegebene angestrebte Wert der Homogenität erreicht ist. Über die Steuerleitung 49 wird nun die Stromquelle 50 und damit die Heizwiderstände 18 abgeschaltet, und die Supraleitungs-Schalter 14, 15, 16, 17 schalten die Zusatzspulen 10, 11, 12, 13 sowie die Hauptspule 25 in den "persistent mode".

Man kann erfindungsgemäß auch die Hauptspule 25 unmittelbar nach Einspeisen des Nennstromes $i_m$ "persistent" schalten, um sich für die nachfolgenden Schritte die hohe Stabilität der supraleitenden Hauptspule 25 zunutze zu machen. Allerdings muß man in diesem Fall prüfen, ob durch das spätere Einspeisen der Korrekturströme $i_1$ bis $i_4$ in die Zusatzspulen 10 bis 13 Strombeiträge in die Hauptspule 25 induziert wurden, die das Hauptfeld in störendem Umfang verändern. Ist dies der Fall, muß die Prozedur mit einem korrigierten Nennstrom $i'_m$ wiederholt werden.

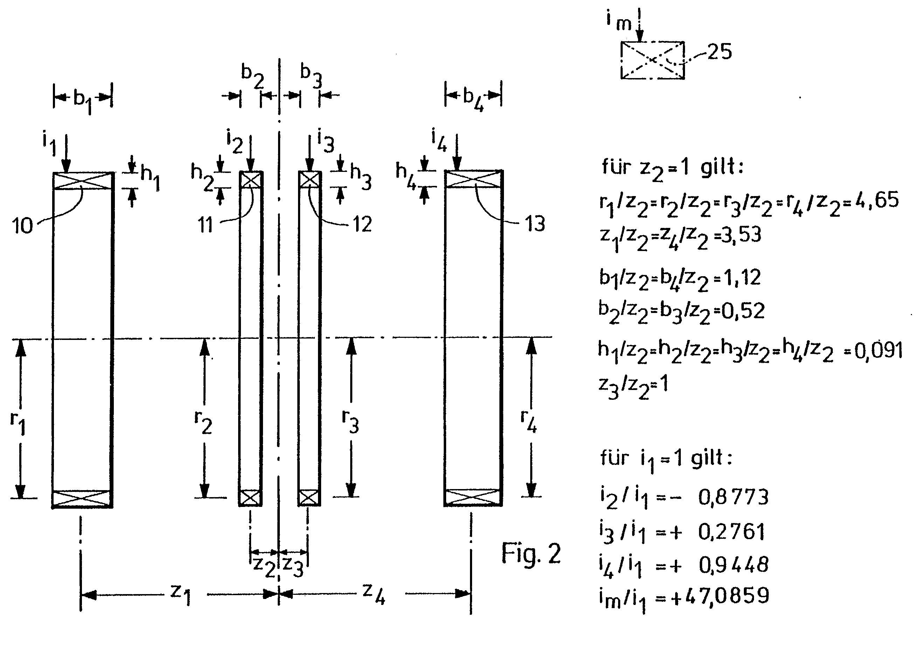

Fig. 2 zeigt ein berechnetes Ausführungsbeispiel mit vier Zusatzspulen 10, 11, 12, 13, wobei wiederum die Spulen 10, 13 und 11, 12 paarweise zueinander angeordnet sind. Beim Ausführungsbeispiel sind die Radien $r_1$, $r_2$, $r_3$, $r_4$, der Mittelpunkte der Spulenpakete von der Längsachse 20 gleich groß. Auch die Höhen $h_1$, $h_2$, $h_3$, $h_4$ der Spulenpakete sind bei allen vier Spulen gleich groß, und die Breiten $b_1$, $b_4$ des Spulenpaares 10, 13 sowie die Breiten $b_2$, $b_3$ des Spulenpaares 11, 12 sind jeweils untereinander gleich.

Normiert auf den radialen Abstand $z_2$ der Spule 11 vom Schnittpunkt der Achsen 20, 21 gilt für die übrigen Abmessungen des Korrekturspulensystems:

$$r_1/z_2 = r_2/z_2 = r_3/z_2 = r_4/z_2 = 4,65$$
$$z_1/z_2 = z_4/z_2 = 3.53$$
$$b_1/z_2 = b_4/z_2 = 1,12$$
$$b_2/z_2 = b_3/z_2 = 0,52$$
$$h_1/z_2 = h_2/z_2 = h_3/z_2 = h_4/z_2 = 0,091$$
$$z_3/z_2 = 1$$

Setzt man den Korrekturstrom $i_1$ in der Zusatzspule 10 als Bezugsgröße an, gilt für die übrigen Ströme in normierter Schreibweise:

$$i_2/i_1 = -0,8773$$
$$i_3/i_1 = +0,2761$$
$$i_4/i_1 = -0,9448$$
$$i_m/i_1 = +47,0859$$

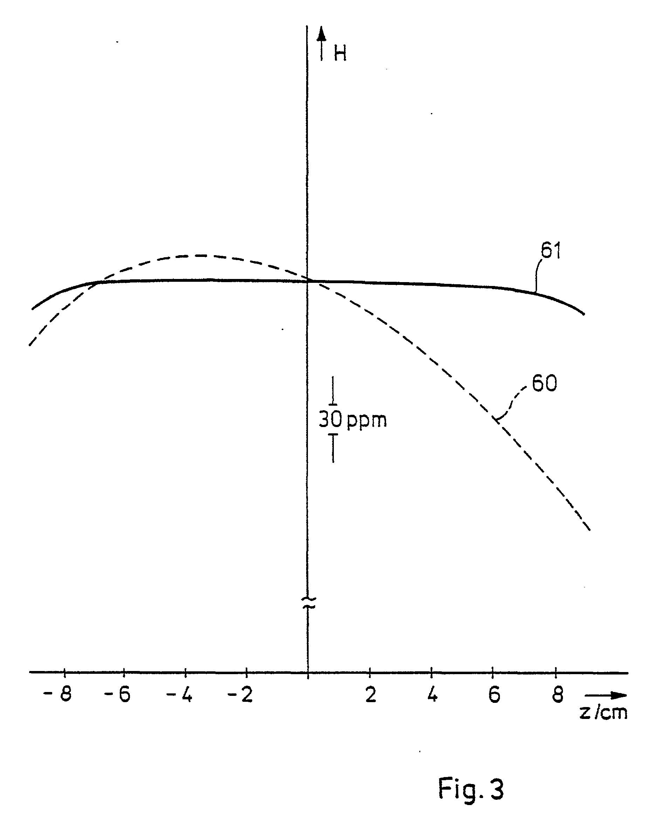

Das Ergebnis der Homogenisierung mit einem Korrekturspulensystem gemäß Fig. 2 ist in Fig. 3 dargestellt.

Das gestrichelt eingezeichnete Feldprofil 60 entspricht dem Profil des von der Hauptspule 25 erzeugten, nicht korrigierten Hauptfeldes. Nach Durchführung des erfindungsgemäßen Verfahrens bzw. mit der erfindungsgemäßen Vorrichtung wurden nun die vorstehend beispielhaft zahlenmäßig genannten Werte eingestellt, und es ergab sich das durchgezogen eingezeichnete Profil 61 des korrigierten Feldes.

Man erkennt deutlich, daß eine wesentliche Verbesserung der Homogenität um mehrere Größenordnungen erreicht wurde, weil in einem axialen Probenraum von mehreren Zentimetern nur eine Inhomogenität des korrigierten Feldes von wenigen ppm ($10^{-6}$) erkennbar ist, während bei unkorrigiertem Feld die Inhomogenität bei über 100 ppm ($10^{-4}$) liegt.

Im Rahmen der vorliegenden Erfindung soll kein Schutz für irgendwelche Verfahrensschritte an sich begehrt werden, in denen Rechenoperationen als Zwischenschritte erforderlich sind.

## Patentansprüche

1. Verfahren zum Homogenisieren des Feldes (H) einer aus einer Haupt-Stromquelle (250) und supraleitend betreibbaren und mit Supraleitungs-Schaltern kurzschließbaren Magnet-Hauptspule (25) und mindestens zwei von der Hauptspule getrennten Zusatzspulen (10 bis 13) mit nicht verschwindenden Feldgradienten ($g_{11}$ ..., $g_{pp}$) mindestens erster bis p-ter Ordnung in der Spulenachse (z) bestehenden Spulenanordnung, umfassend die folgenden Schritte:

a) Anschließen der Zusatzspulen (10 bis 13) an jeweils eine gesonderte Stromquelle (200, 210, 220, 230) und einen das Kurzschließen der jeweiligen Zusatzspule gestattenden Supraleitungs-Schalter (14 bis 17);

b) Kühlen der Hauptspule (25) und der Zusatzspulen (10 bis 13) auf eine die Supraleitung ermöglichende Temperatur;

c) Speisen der Hauptspule (25) mit Nennstrom ($i_m$);

d) Messen des Profils der Hauptspule (25);

e) Ermitteln der Gradienten ($G_1$ ..., $G_p$) der Hauptspule (25) aus dem gemessenen Profil;

f) Ermitteln der Gradienten ($g_{11}$ ..., $g_{pp}$) der Zusatzspulen (10 bis 13);

g) Ermitteln von Korrekturströmen ($i_1$ ..., $i_p$) für die Zusatzspulen (10 bis 13) aus dem Gleichungssystem:

$$\sum_{n=1}^{p} g_{n1} i_1 = -G_1 i_m$$

$$\sum_{n=1}^{p} g_{n2} i_2 = -G_2 i_m$$

$$\vdots \qquad \vdots$$

$$\sum_{n=1}^{p} g_{np} i_p = -G_p i_m;$$

h) Einspeisen der ermittelten Korrekturströme ($i_1$ ..., $i_p$) in die Zusatzspulen (10 bis 13);

i) Schließen der Supraleitungs-Schalter (14 bis 17) der Zusatzspulen (10 bis 13).

2. Verfahren nach Anspruch 1, dadurch gekennzeichnet, daß die Gradienten ($g_{11}$ ..., $g_{pp}$) der Zusatzspulen (10 bis 13) aus deren Geometrie bestimmt werden.

3. Verfahren nach Anspruch 1, dadurch gekennzeichnet, daß die Gradienten ($g_{11}$ ..., $g_{pp}$) der Zusatzspulen (10 bis 13) dadurch bestimmt werden, daß die Zusatzspulen (10 bis 13) mit einem Referenzstrom gespeist, ihre Profile gemessen und die Gradienten ($g_{11}$ ..., $g_{pp}$) aus den Profilen bestimmt werden.

4. Verfahren nach einem der Ansprüche 1 bis 3, dadurch gekennzeichnet, daß nach dem Einspeisen der Korrekturströme ($i_1$ ..., $i_p$) der Supraleitungs-Schalter der Hauptspule (25) geschlossen wird.

5. Verfahren nach einem der Ansprüche 1 bis 3, dadurch gekennzeichnet, daß der Supraleitungs-Schalter der Hauptspule (25) nach dem Speisen mit Nennstrom ($i_m$) geschlossen, nach dem Einspeisen der Korrekturströme ($i_1$ ..., $i_p$) das Feld der Hauptspule (25) gemessen und bei Überschreiten einer vorgegebenen Abweichung von einem nennstromabhängigen Wert die Schritte c) bis i) mit einem korrigierten Nennstrom ($i'_m$) wiederholt werden.

6. Verfahren nach einem der Ansprüche 1 bis 5, gekennzeichnet durch eine zyklische Wiederholung der Schritte d) bis i) bis zum Erreichen einer vorgegebenen Abweichung des Profils (61) des korrigierten Hauptfeldes ($H_m$) von einem vorgegebenen Soll-Profil.

7. Vorrichtung zum Homogenisieren des Feldes (H) einer aus einer Haupt-Stromquelle (250) und supraleitend betreibbaren und mit Supraleitungs-Schaltern kurzschließbaren Magnet-Hauptspule (25) und mindestens zwei von der Hauptspule getrennten Zusatzspulen (10 bis 13) mit nicht verschwindenden Feldgradienten ($g''$, ..., $g_{pp}$) mindestens erster bis p-ter Ordnung in der Spulenachse (z) bestehenden Spulenanordnung, mit einem einen entlang einer Spulenachse (z) verfahrbaren Sensor (34) aufweisenden Magnet-Meßgerät (31), dadurch gekennzeichnet, daß die Zusatzspulen (10 bis 13) als supraleitende Spulen mit parallel geschalteten Supraleitungs-Schaltern (14 bis 17) ausgebildet sind, daß die Zusatzspulen (10 bis 13) mit je einer Stromquelle (200, 210, 220, 230) verbunden sind, daß ein Ausgang des Magnetfeld-Meßgerätes (31) mit einem Feldprofil-Speicher (41) verbunden ist und daß der Feldprofil-Speicher (41) und ein Steuergerät (30) an ein Rechenwerk (43) angeschlossen sind, dessen Ausgänge mit einem Gradientenspeicher (45) sowie der Haupt-Stromquelle (250) und den Stromquellen (200, 210, 220, 230) für die Zusatzspulen (10 bis 13) verbunden sind.

## Claims

1. Method for homogenizing the field (H) of a coil arrangement comprising a main power supply (250) and a main field coil (25) operable in superconducting manner and short-circuitable with superconduction switches and at least two additional coils (10 to 13) separated from the main coil and having non-disappearing field gradients ($g_{11}$ ... $g_{pp}$) of at least the first to the pth order in the coil axis (z), comprising the following stages:

a) connecting the additional coils (10 to 13) to in each case one separate power supply (200, 210, 220, 230) and a superconduction switch (14 to 17) permitting the short-circuiting of the particular additional coil,

b) cooling the main coil (25) and additional coils (10 to 13) to a temperature permitting superconduction,

c) supplying the main coil (25) with rated current ($i_m$),

d) measuring the profile of the main coil (25),

e) determining the gradients ($G_1$ ..., $G_p$) of the main coil (25) from the measured profile,

f) determining the gradients ($g_{11}$ ..., $g_{pp}$) of the additional coils (10 to 13),

g) determining the correcting currents ($i_1$ ..., $i_p$) for the additional coils (10 to 13) from the equation system:

$$\sum_{n=1}^{p} g_{n1} i_1 = -G_1 i_m$$

$$\sum_{n=1}^{p} g_{n2} i_2 = -G_2 i_m$$

$$\sum_{n=1}^{p} g_{np} i_p = -G_p i_m$$

h) feeding the determined correcting currents ($i_1$ ..., $i_p$) into the additional coil (10 to 13), and i) closing the superconduction switch (14 to 17) of the additional coils (10 to 13).

2. Method according to claim 1, characterized in that the gradients ($g_{11}$ ..., $g_{pp}$) of the additional coils (10 to 13) are determined from their geometry.

3. Method according to claim 1, characterized in that the gradients ($g_{11}$ ..., $g_{pp}$) of additional coils (10 to 13) are determined in that said additional coils (10 to 13) are supplied with a reference current, their profiles measured and the gradients ($g_{11}$ ..., $g_{pp}$) determined from the profiles.

4. Method according to one of the claims 1 to 3, characterized in that after feeding in the correct currents ($i_1$ ..., $i_p$) the superconduction switch of the main coil (25) is closed.

5. Method according to one of the claims 1 to 3, characterized in that the superconduction switch of the main coil (25) is closed after feeding in rated current ($i_m$), the field of the main coil (25) is measured after feeding in the correcting currents ($i_1$ ..., $i_p$) and on exceeding a predetermined divergence from a rated current-dependent value, steps c) to i) are repeated with a corrected rated current ($i'_m$).

6. Method according to one of the claims 1 to 5, characterized by a cyclic repetition of steps d) to i) until a predetermined divergence of the profile (61) of the corrected main field ($H_m$) from a predetermined desired profile is obtained.

7. Apparatus for homogenizing the field (H) of a coil arrangement comprising a main power supply (250) and a main field coil (25) operable in superconducting manner and short-circuitable with superconducting switches and at least two additional coils (10 to 13), separated from the main coil and having non-disappearing field gradients ($g_{11}$ ..., $g_{pp}$) of at least the first to the pth order in the coil axis (z), with a magnetic field measuring device (31) having a sensor (34) movable along a coil axis (z), characterized in that the additional coils (10 to 13) are constructed as superconducting coils with parallel-connected superconduction switches (14 to 17), that the additional coils (10 to 13) are in each case connected to a power supply (200, 210, 220, 230), that an output of the magnetic field measuring device (31) is connected to a field profile memory (41) and that the latter and a control device (30) are connected to an arithmetic and logic unit (43), whose outputs are connected to a gradient memory (45), as well as the main power supply (25) and the power supplies (200, 210, 220, 230) for the additional coils (10 to 13).

**Revendications**

1. Procédé d'homogénéisation du champ (H) d'un agencement de bobines constitué par une source de courant principale (250) et par une bobine principale d'aimant (25), qui peut être excitée de manière supraconductrice et être court-circuitée avec des commutateurs à supraconduction, et par au moins deux bobines supplémentaires (10 à 13), séparées de la bobine principale et présentant des gradients de champ ($g_{11}$..., $g_{pp}$) qui ne sont pas infimes, au moins du premier ordre jusqu'à l'ordre p dans l'axe des bobines (z), comprenant les étapes suivantes:

a) le branchement des bobines supplémentaires (10 à 13) chacune à une source de courant séparée (200, 210, 220, 230) et à un commutateur à supraconduction (14 à 17) permettant le court-circuitage de chaque bobine supplémentaire,

b) le refroidissement de la bobine principale (25) et des bobines supplémentaires (10 à 13) à une température rendant possible la supraconduction,

c) l'alimentation de la bobine principale (25) avec un courant nominal ($i_m$),

d) la mesure du profil de la bobine principale (25),

e) la détermination des gradients ($G_1$ ..., $G_p$) de la bobine principale (25) à partir du profil mesuré,

f) la détermination des gradients ($g_{11}$ ..., $g_{pp}$) des bobines supplémentaires (10 à 13),

g) la détermination des courants de correction ($i_1$ ..., $i_p$) pour les bobines supplémentaires (10 à 13) par le système d'équation:

$$\sum_{n=1}^{p} g_{n1} i_1 = -G_1 i_m$$

$$\sum_{n=1}^{p} g_{n2} i_2 = -G_2 i_m$$

$$\vdots \qquad \vdots$$

$$\sum_{n=1}^{p} g_{np} i_p = -G_p i_m;$$

h) l'alimentation des courants de correction déterminés ($i_1$ ..., $i_p$) aux bobines supplémentaires (10 à 13),

i) la fermeture des commutateurs à supraconduction (14 à 17) des bobines supplémentaires (10 à 13).

2. Procédé suivant la revendication 1, caractérisé en ce que les gradients ($g_{11}$ ..., $g_{pp}$) des bobines supplémentaires (10 à 13) sont déterminés par la géométrie de ces dernières.

3. Procédé suivant la revendication 1, caractérisé en ce que les gradients ($g_{11}$ ..., $g_{pp}$) des bobines supplémentaires (10 à 13) sont déterminés par le fait que les bobines supplémentaires (10 à 13) sont alimentées en un courant de référence, leurs profils sont mesurés et les gradients ($g_{11}$ ..., $g_{pp}$) sont déterminés à partir des profils.

4. Procédé suivant l'une quelconque des revendications 1 à 3, caractérisé en ce qu'après l'alimentation des courants de correction ($i_1$ ..., $i_p$), le commutateur à supraconduction de la bobine principale (25) est fermé.

5. Procédé suivant l'une quelconque des revendications 1 à 3, caractérisé en ce que le commutateur à supraconduction de la bobine principale (25) est fermé après l'alimentation avec le courant nominal ($i_m$), en ce que le champ de la bobine principale (25) est mesuré après l'alimentation des courants de correction ($i_1$..., $i_p$) et, en ce que lors d'un dépassement d'une divergence prédéterminée par rapport à une valeur dépendant du courant nominal, les étapes c) à i) sont répétées avec un courant nominal corrigé ($i'_m$).

6. Procédé suivant l'une quelconque des revendications 1 à 5, caractérisé par une répétition cyclique des étapes d) à i) jusqu' à l'obtention d'une divergence prédéterminée du profil (61) du champ principal ($H_m$) corrigé par rapport à un profil de consigne prédéterminé.

7. Dispositif d'homogénéisation du champ (H) d'un agencement de bobines constitué par une source de courant principale (250) et par une bobine principale d'aimant (25) qui peut être excitée de manière supraconductrice et être court-circuitée avec des commutateurs à supraconduction, et par au moins deux bobines supplémentaires (10 à 13), séparées de la bobine principale et présentant des gradients de champ ($g_{11}$ ..., $g_{pp}$) qui ne sont pas infimes, au moins du premier ordre jusqu'à l'ordre p dans l'axe des bobines (z), comprenant un appareil de mesure du champ magnétique (31) présentant un détecteur (34) qui peut être déplacé le long d'un axe des bobines (z), caractérisé en ce que les bobines supplémentaires (10 à 13) sont réalisées sous la forme de bobines supraconductrices ayant des commutateurs à supraconduction (14 à 17) montés en parallèle, en ce que les bobines supplémentaires (10 à 13) sont connectées chacune à une source de courant (200, 210, 220, 230), en ce qu'une sortie de l'appareil de mesure (31) du champ magnétique est connectée à une mémoire (41) du profil de champ et en ce que la mémoire (41) du profil de champ et une unité de commande (30) sont raccordés à un calculateur (43) dont des sorties sont connectées à une mémoire de gradients (45) ainsi qu'à la source de courant principal (250) et aux sources de courant (200, 210, 220, 230) pour les bobines supplémentaires (10 à 13).

Fig. 1

EP 0 200 891 B1

Fig. 2

für $z_2 = 1$ gilt:

$r_1/z_2 = r_2/z_2 = r_3/z_2 = r_4/z_2 = 4,65$
$z_1/z_2 = z_4/z_2 = 3,53$
$b_1/z_2 = b_4/z_2 = 1,12$
$b_2/z_2 = b_3/z_2 = 0,52$
$h_1/z_2 = h_2/z_2 = h_3/z_2 = h_4/z_2 = 0,091$
$z_3/z_2 = 1$

für $i_1 = 1$ gilt:

$i_2/i_1 = - \ 0,8773$
$i_3/i_1 = + \ 0,2761$
$i_4/i_1 = + \ 0,9448$
$i_m/i_1 = + 47,0859$

EP 0 200 891 B1

Fig. 3